# EUROPEAN PATENT SPECIFICATION

(11) **EP 1 294 537 B1**
(45) Date of publication and mention of the grant of the patent: **30.03.2005**
(21) Application number: 01957542.2
(22) Date of filing: 29.06.2001
(51) Int. Cl.: B24B 37/04, B24B 41/06

(54) **WAFER CARRIER WITH GROOVE FOR DECOUPLING RETAINER RING FROM WAFER**
WAFER-TRÄGER MIT KERBE ZUR ENTKOPPELUNG VON HALTERING UND HALTERPLATTE
SUPPORT DE TRANCHE DOTE D'UNE RAINURE PERMETTANT DE DECOUPLER UNE BAGUE DE RETENUE A PARTIR DE LA TRANCHE

(30) Priority: 30.06.2000 US 608510
(43) Date of publication of application: 26.03.2003
(73) Proprietor: LAM RESEARCH CORPORATION, Fremont, CA 94538 (US)
(72) Inventor: GOTKIS, Yehiel, Fremont, CA 94538 (US); OWCZARZ, Aleksander, A., San Jose, CA 95135 (US)
(74) Representative: Thomson, Paul Anthony
(86) International application number: PCT/US2001/041204
(87) International publication number: WO 2002/002275

(56) References cited:
- EP-A- 0 776 730
- EP-A- 0 861 706
- WO-A-00/27584

## Description

### BACKGROUND OF THE INVENTION

### 1. Field of the Invention

The present invention relates to chemical mechanical planarization (CMP), and more particularly to wafer carriers for reducing edge effects during wafer processing by CMP.

### 2. Description of the Related Art

Fabrication of semiconductor devices from semiconductor wafers generally requires, among others, chemical mechanical planarization (CMP), buffing, and cleaning of the wafers. Modern integrated circuit devices typically are formed in multi-level structures. At the substrate level, for example, transistor devices are formed. In subsequent levels, interconnect metallization lines are patterned and electrically connected to the transistor devices to define the desired functional device. As is well known, patterned conductive features are insulated from each other by dielectric material, such as silicon dioxide, for example. As more metallization levels and associated dielectric layers are formed, the need to planarize the dielectric material increases. Without planarization, fabrication of additional metallization layers becomes substantially more difficult due to the higher variations in the surface topography. In other applications, metallization line patterns are formed in the dielectric material, and then metal CMP operations are performed to remove excessive metallization.

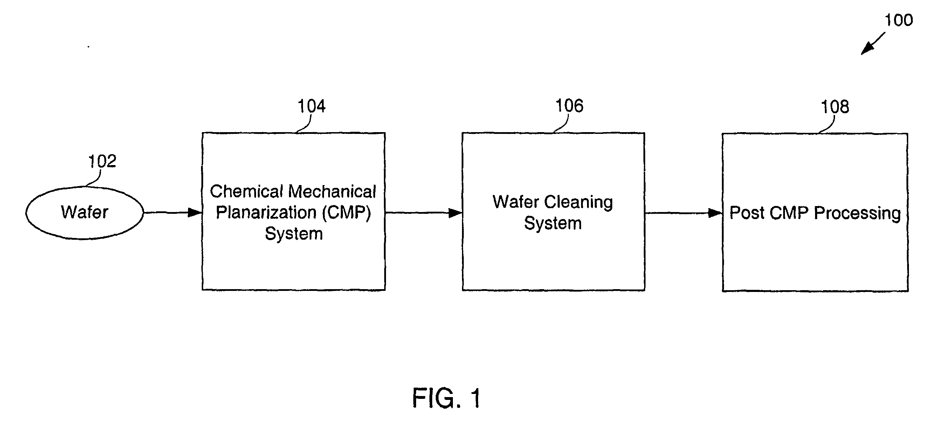

Figure 1 shows a schematic diagram of a chemical mechanical planarization (CMP) process 100 performed on a semiconductor wafer 102. In this process 100, the wafer 102 undergoes a CMP process in a CMP system 104. Then, the semiconductor wafer 102 is cleaned in a wafer cleaning system 106. The semiconductor wafer 102 then proceeds to a post-CMP processing 108, where the wafer 102 undergoes different subsequent fabrication operations, including deposition of additional layers, sputtering, photolithography, and associated etching.

The CMP system 104 typically includes system components for handling and planarizing the surface topography of the wafer 102. Such components can be, for example, an orbital or rotational polishing pad, or a linear belt-polishing pad. The pad itself is typically made of an elastic polymeric material. For planarizing the surface topography of the wafer 102, the pad is put in motion and a slurry material is applied and spread over the surface of the pad. Once the pad with the slurry is moving at a desired rate, the wafer 102, which is mounted on a wafer carrier, is lowered onto the surface of the pad for planarizing the topography of the wafer surface.

In rotational or orbital CMP systems, a polishing pad is located on a rotating planar surface, and the slurry is introduced onto the polishing pad. In orbital tools the velocity is introduced via pad orbital motion and wafer carrier rotation and the slurry is introduced from underneath the wafer through multiple holes in the polishing pad. Through these processes, a desired wafer surface is polished to provide a smooth planar surface. The wafer is then provided to the wafer cleaning system 106 to be cleaned.

One of the main goals of CMP systems is to ensure the uniform removal rate distribution across the wafer surface. As is well known, the removal rate is defined by Preston's equation: Removal Rate = KpPV, where the removal rate of material is a function of loading pressure P. and relative velocity V. The term, Kp, is Preston Coefficient, which is a constant determined by the composition of the slurry, the process temperature, and the pad surface.

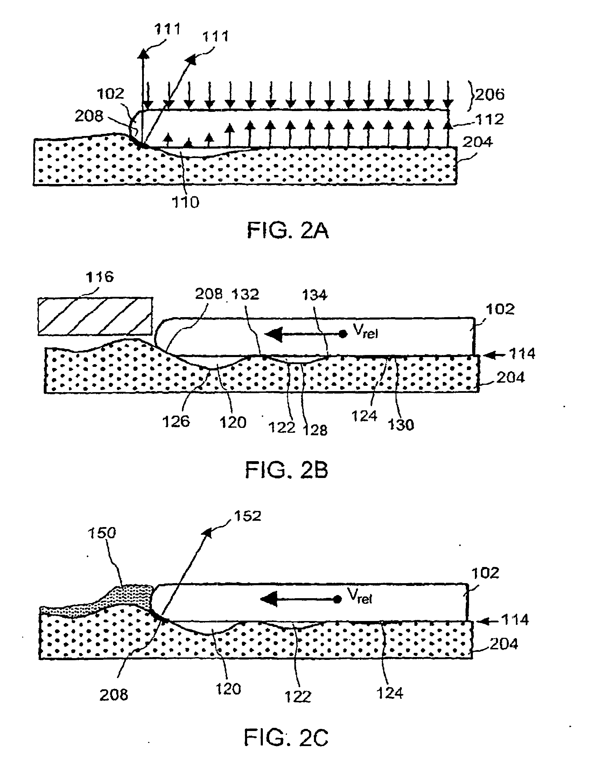

Unfortunately, conventional CMP systems often suffer from edge effects that redistribute the removal rate and thus the uniformity across the wafer surface. The edge effects typically result from boundary conditions between a wafer edge and a polishing pad during CMP processing. Figure 2A shows a cross-sectional view of a static model of conventional edge effect between a section of the wafer 102 and a polishing pad 204. In this static model, a uniform pressure is exerted on the wafer 102 in the form of a downforcc as indicated by vectors 206. This down force 206, however, causes a deformation, which is indicated by vectors 112, of the pad 204 that is essentially transversal (i.e., normal) but with a substantial longitudinal-transversal perturbation zone near the edge 208 of the wafer 102. Thus, this deformation results in a lower pressure zone 110 near the edge 208. The edge 208 of the wafer 102 causes high pressure as indicated by vectors 111, thereby producing non-uniform pressure areas near the edge 208.

The creation of attempting pressure zones leads to non-uniform remove rate across the wafer. Figure 2B illustrates a cross-sectional view of a dynamic model of the edge effect between a section of the wafer 102 and the polishing pad 204. A section of a retaining ring 116 retains the wafer 102 in place to retain the wafer 102 in a wafer carrier (not shown) that controls the movement of the wafer 102. In this configuration, the wafer 102 is in motion relative to the polishing pad 204 as indicated by vector *V*_{*rel*}. The pad 204 is generally elastic. As the wafer 102 moves with the relative velocity *V*_{*rel*} over the pad 204, it thus causes elastic perturbation on the surface of the pad 204.

The translational motion of the wafer 102 and the elastic perturbation produce a longitudinal-transversal pad deformation wave on the surface 114 of the polishing pad 204 according to conventional wave generation theory. The deformation wave is typically a fast relaxing wave due to suppressive action of the extended wafer surface and the high viscosity of the pad material. This causes local redistribution of the loading and pressures near the edge 208 of the wafer 102. For example, low pressure zones 120, 122, and 124 arc formed on the surface 114 of the pad 204 with progressively higher pressures relative to the distance from the edge 208 of the wafer 102.

Each of the low pressure zones 120, 122, and 124 is defined by local minimum and maximum pressure regions that cause uneven planarization of the surface topography. For example, the local minimum pressure region 126 of the low pressure zone 120 causes lower removal rates, resulting in local under-planarization of the surface topography. Conversely, the local maximum pressure region 128 of the low pressure zone 120 causes higher removal rates, resulting in local over-planarization of the surface topography. Thus, the overall planarization efficiency of the wafer 102 is substantially degraded.

Furthermore, in conventional CMP systems the frontal wave maximum produces sealing effect at the edge of a wafer that substantially reduces entry of slurry under the wafer. Figure 2C shows a cross-sectional view of a sealing effect between a section of the wafer 102 and the polishing pad 204. The slurry is initially provided over the surface 114 of the polishing pad 204. As the wafer 102 moves with velocity Vrel relative to the polishing pad 204, the edge 208 of the wafer causes a high pressure as indicated by vector 152. This high pressure causes loading concentration of the slurry 150 at the edge 208 of the wafer 102, thereby restricting slurry transport underneath the wafer 102. In addition, high loading at the edge 208 may squeeze out the slurry out of pores and grooves of the polishing pad 204, creating slurry starvation conditions. As a result, internal sections of the wafer surface may not be provided with adequate amount of slurry for effective CMP processing.

Additionally, low pressure zones stimulate redeposition processes that can cause increased surface defectivity. Specifically, conventional CMP systems utilize dissolution and surface modification reactions, which are typically reducing volume type reactions stimulated by high pressure. In these reactions, pressure drops reverse the reaction, causing the redeposition of dissolved by-products back to the wafer surface. Re-deposited material typically has uncontrollable composition and glues other particles to the wafer surface. This makes cleaning of the wafer substantially more difficult.

EP 0776730 discloses a wafer carrier for use with a chemical mechanical planarization apparatus including a vacuum chuck configured to hold and rotate a wafer for planarizing a surface topography of the wafer on a polishing pad. The vacuum chuck comprises a rigid plate made from metal, hard synthetic resin or glass.

In view of the foregoing, what is needed is a wafer carrier that can minimize edge effects on a wafer during CMP processing while reducing slurry sealing effect.

### SUMMARY OF THE INVENTION

According to the present invention there is provided a wafer carrier as claimed in claim 1. According to a further aspect of the present invention there is provided a chemical mechanical planarization system as claimed in claim 7. According to a yet further aspect of the present invention there is provided a method for making a wafer carrier as claimed in claim 12.

Broadly speaking, the present invention fills these needs by providing a wafer carrier that provides uniform removal rates by masking the edge of a wafer to be polished. The wafer carrier allows a retainer ring and a wafer to independently align to the surface of a polishing pad to substantially eliminate detrimental edge and sealing effects. It should be appreciated that the present invention can be implemented in numerous ways, including as a process, an apparatus, a system, a device or a method. Several inventive embodiments of the present invention are described below.

In one embodiment, the present invention provides a wafer carrier for use with a chemical mechanical planarization apparatus. The wafer carrier includes a vacuum chuck and a retainer ring. The vacuum chuck is configured to hold and rotate a wafer for planarizing a surface topography of the wafer on a polishing pad. The vacuum chuck includes an inner region for holding the wafer and an outer region and further includes a groove adapted to decouple the inner region and the outer region. The inner and outer regions of the vacuum chuck are arranged to move independently in a direction orthogonal to a polishing surface of the polishing pad. The retainer ring is disposed on the outer region of the vacuum chuck and is configured to retain the wafer during CMP processing. In this configuration, the decoupled retainer ring and the wafer are arranged to move independently to align to the polishing surface of the polishing pad during CMP processing.

In another embodiment, a wafer carrier for use with a chemical mechanical planarization apparatus is disclosed. The wafer carrier includes a vacuum chuck and a retainer ring. The vacuum chuck is configured to hold and rotate a wafer for planarizing a surface topography of the wafer on a polishing pad and includes an inner region for holding the wafer and an outer region. The vacuum chuck is elastomeric and includes a groove adapted to decouple the inner region and the outer region. The inner and outer regions of the vacuum chuck are arranged to move independently in a direction orthogonal to a polishing surface of the polishing pad. The retainer ring is disposed on the outer region of the vacuum chuck and is configured to retain the wafer during CMP processing. The decoupled retainer ring and the wafer are arranged to move independently to align to a plane defining the polishing surface of the polishing pad during CMP processing.

In yet another embodiment, the present invention provides a wafer carrier for use with a chemical mechanical planarization apparatus. The wafer carrier includes a vacuum chuck, a retainer ring, and a vacuum port. The vacuum chuck is configured to hold and rotate a wafer for polishing the wafer on a polishing pad and includes an inner region for holding the wafer and an outer region. The vacuum chuck further includes a groove adapted to decouple the inner region and the outer region, wherein the inner and outer regions of the vacuum chuck are arranged to move independently of each other. The vacuum port is configured to provide a vacuum force to the vacuum chuck. The retainer ring is disposed on the outer region of the vacuum chuck and is configured to retain the wafer during CMP processing. In this configuration, the decoupled retainer ring and the wafer are arranged to move independently in a direction orthogonal to the polishing surface of the polishing pad such that the retainer ring and the wafer align to the polishing surface of the polishing pad.

Advantageously, the decoupled retainer ring effectively masks the edge of the wafer to minimize detrimental edge effects on the wafer during CMP processing and improves uniform removal rate. Preferably, the leading edge of the retaining is shaped in a rounded fashion to reduce the pressure so that the formation low pressure zones under the retaining ring 304 is minimized. This also minimizes the undesirable slurry sealing effect and further enhances uniform removal rate, thereby enhancing the uniform planarization of the wafer. Other aspects and advantages of the present invention will become apparent from the following detailed description, taken in conjunction with the accompanying drawings, illustrating by way of example the principles of the present invention.

### BRIEF DESCRIPTION OF THE DRAWINGS

The present invention will be readily understood by the following detailed description in conjunction with the accompanying drawings. To facilitate this description, like reference numerals designate like structural elements.
Figure 1 shows a schematic diagram of a chemical mechanical planarization (CMP) process performed on a semiconductor wafer.
Figure 2A shows a cross-sectional view of a static model of conventional edge effect between a section of the wafer and a polishing pad.
Figure 2B illustrates a cross-sectional view of a dynamic model of the edge effect between a section of the wafer and the polishing pad.
Figure 2C shows a cross-sectional view of a sealing effect between a section of the wafer and the polishing pad.
Figure 3A shows a cross sectional view of an exemplary wafer carrier in accordance with one embodiment of the present invention.
Figure 3B illustrates a cross-sectional view of a wafer carrier with a modified retaining ring in accordance with one embodiment of the present invention.
Figure 4 shows an exploded view of the wafer carrier in accordance with one embodiment of the present invention.
Figure 5A shows a cross-sectional view of a section of the wafer and a retaining ring that are arranged to mask the edge effect of the wafer in accordance with one embodiment of the present invention.
Figure 5B shows a cross-sectional view of a section of the wafer and the retaining ring that are arranged to reduce the edge effect of the retaining ring in accordance with one embodiment of the present invention.

### DETAILED DESCRIPTION OF THE PREFERRED EMBODIMENTS

The present invention provides a wafer carrier that decouples a retainer ring from a wafer during CMP processing to allow the retainer ring and the wafer to automatically align to the polishing surface of a polishing pad. In the following description, numerous specific details are. set forth in order to provide a thorough understanding of the present invention. It will be understood, however, to one skilled in the art, that the present invention may be practiced without some or all of these specific details. In other instances, well known process operations have not been described in detail in order not to unnecessarily obscure the present invention.

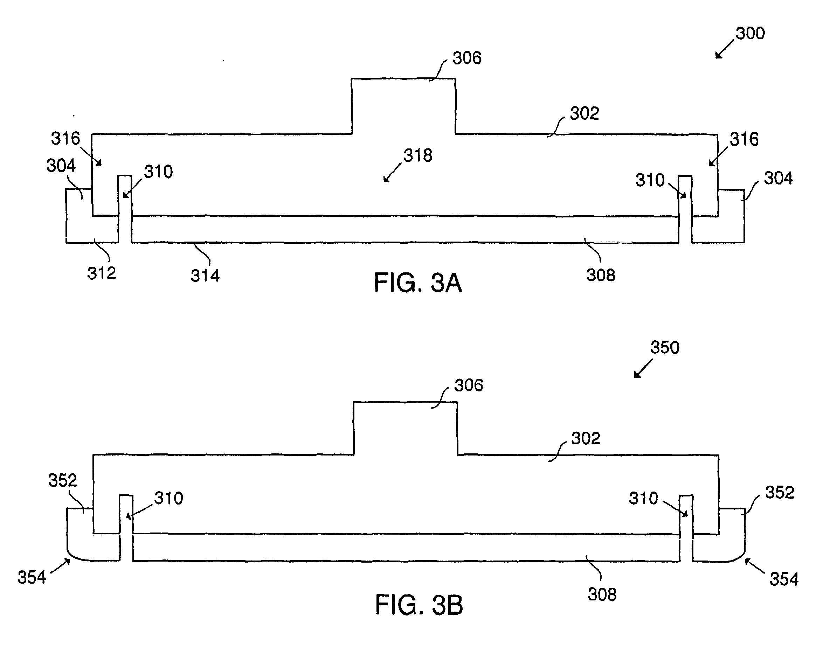

Figure 3A shows a cross sectional view of an exemplary wafer carrier 300 in accordance with one embodiment of the present invention. The wafer carrier 300 is configured to hold and rotates a wafer 308 during CMP processing. Specifically, the wafer carrier includes a vacuum chuck 302, an active retaining ring 304, and a vacuum port 306. The vacuum chuck 302 is preferably circular and elastic, and is made of an elastic material such as rubber. The retaining ring 304 is disposed around the elastomeric vacuum chuck 302 to retain a water 308 in place during CMP processing. Preferably, the retaining ring 304 is arranged such that its bottom surface 312 is substantially flush or even with a surface 314 of the wafer to be polished.

A decoupling groove 310 (e.g., trench, channel, etc.) is formed near the outer edge of the vacuum chuck 302 and defines a pair of regions 316 and 318 in the vacuum chuck 302. The retaining ring 304 is disposed on region 316, which lies along the outer edge of the vacuum chuck 302. The wafer is disposed on region 318 on the inner region of the vacuum chuck 302 by a vacuum force provided through the vacuum port 306.

In this configuration, the decoupling groove 310 is configured to effectively decouple the regions 316 and 318 in the elastomeric vacuum chuck 302. The decoupling of the regions 316 and 318 allows the attached retaining ring 304 and the wafer 308 to align independently to the plane of a polishing surface on a polishing pad. This is because the elasticity of the vacuum chuck 302 allows the wafer 308 and the retaining ring 304 to move independent of each other in a direction orthogonal to the wafer 308. Thus decoupled, both the retaining ring 304 and the wafer 308 can be independently aligned to the polishing surface under polishing pressure. As will be discussed in more detail below, this self-aligning feature of the retaining ring 304 and the wafer 308 effectively masks the edge of the wafer 308 during CMP processing. thereby substantially eliminating the undesirable edge effects.

To further ensure elimination of residual edge effects, the retaining ring 304 may be configured to suppress edge effects that may arise from the edge of the ring 304. Figure 3B illustrates a cross-sectional view of a wafer carrier 350 with a modified retaining ring 352 in accordance with one embodiment of the present invention. The wafer carrier 350 is similar to the wafer carrier 300 shown in Figure 3A with the exception of the retaining ring. Specifically, a leading edge 354 of the retaining ring 352 is rounded to eliminate the abrupt edge of the retaining ring 304 shown in Figure 3A. The curvature of the rounded edge 354 of the retaining ring 352 functions to distribute pressure over a larger surface area and thus substantially reduces the ring-related edge effects.

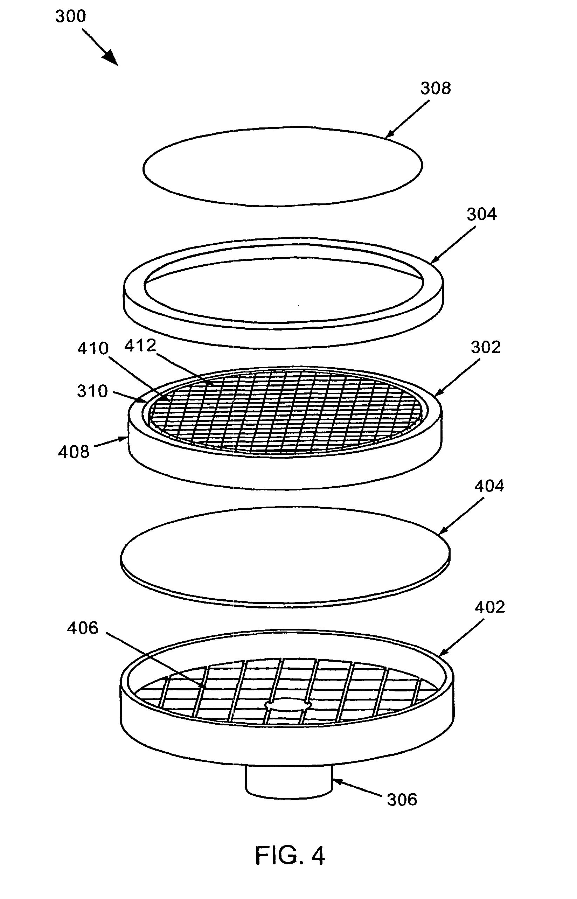

Figure 4 shows an exploded view of the wafer carrier 300 in accordance with one embodiment of the present invention. It should be noted that the wafer carriers of the present invention may be used with any suitable CMP systems such as linear CMP apparatus or rotary CMP apparatus. The wafer carrier 300 includes vacuum chuck 302, retaining ring 304, vacuum port 306, a vacuum chuck body 402, and a vacuum manifold 404. The vacuum chuck body 402 is preferably cylindrical and contains a vacuum distribution grid 406. The vacuum distribution grid 406 is configured to distribute vacuum force from the vacuum port 306. The vacuum manifold 404 is preferably made of a porous material and contains a plurality of pores. The vacuum manifold 404 is disposed over the vacuum distribution grid 406 to transfer vacuum force through the pores.

The vacuum chuck 302 is disposed on the vacuum chuck body 402 and contains a retaining ring section 408, decoupling groove 310, a wafer section 410, and a vacuum grid 412. The decoupling groove 310 decouples the retaining ring section 408 and the wafer section 410 of the vacuum chuck to provide independent alignment to a polishing pad surface. The retaining ring 304 is disposed on the retaining ring section 408 of the vacuum chuck 302. On the other hand, the wafer section 410 defines the area where the wafer 308 is attached via vacuum force. For this purpose, the vacuum grid 412 includes vacuum ports to apply vacuum pressure from the vacuum manifold 404 to the wafer 308 such that the wafer is securely kept in place within the wafer carrier 300.

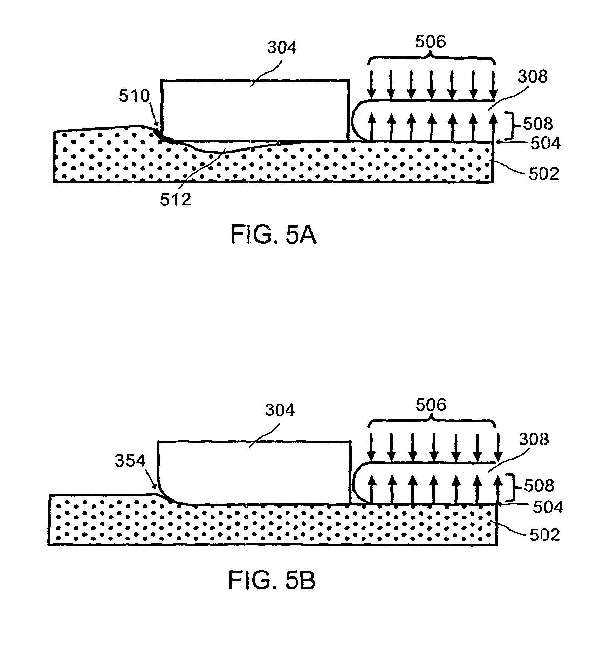

Figure 5A shows a cross sectional view of a section of the wafer 308 and the retaining ring 304 that are arranged to mask the edge effect of the wafer 308 in accordance with one embodiment of the present invention. The wafer 308 and the retaining ring 304 are placed on a polishing pad 502. In this arrangement, the retaining ring 304 and the wafer 308 are decoupled so that both are aligned to the plane of the polishing surface 504 on the polishing pad 502. The presence of the retaining ring 304 moves the high pressure edge point away from the wafer 308 to an outside edge 510 (i.e., leading edge) of the retaining ring 304. Likewise, the decoupled retaining ring 304 moves the low pressure zone 512 away from the wafer 308 to a location near the leading edge of the retaining ring 304. Thus, when a downforce indicated by vectors 506 is applied, the normal pressure vectors 508 under the wafer 308 are substantially uniform in magnitude and direction. In this manner, the retaining ring 304 masks the edge of the wafer 308 from undesirable edge effects by transferring the edge effect from the edge of the wafer 308 to the leading edge 510 of the retaining ring 304. Eliminating the edge effect under the wafer 308, in turn, allows slurry to be provided more evenly under the wafer 308. Accordingly, the planarization efficiency of the wafer 308 in substantially enhanced.

The leading edge 510 of the retaining ring 304 can also be configured to further improve the planarization efficiency as shown above in Figure 3B. Figure 5B shows a cross-sectional view of a section of the wafer 308 and the retaining ring 304 that are arranged to reduce the edge effect of the retaining ring 304 in accordance with one embodiment of the present invention. The wafer 308 and the retaining ring 304 are placed on the polishing pad 502 and are decoupled so that both are aligned to the plane of the polishing surface 504 on the polishing pad 502. The leading edge of the retaining ring 304 is shaped to minimize pressure. In the illustrated embodiment, the leading edge is rounded to reduce the pressure so that the formation low pressure zones under the retaining ring 304 is minimized. This minimizes the undesirable slurry sealing effect, thereby enhancing the uniform planarization of the wafer 508.

While the present invention has been described in terms of several preferred embodiments, it will be appreciated that those skilled in the art upon reading the preceding specifications and studying the drawings will realize various alterations, additions, permutations and equivalents thereof. It is therefore intended that the present invention includes all such alterations, additions, permutations, and equivalents as fall within the scope of the invention as defined by the appended claims.

## Claims

1. A wafer carrier (300) for use with a chemical mechanical planarization apparatus, comprising:
a vacuum chuck (302) configured to hold and rotate a wafer (308) for planarizing a surface topography of the wafer on a polishing pad, the vacuum chuck (302) including an inner region for holding the wafer and an outer region, the vacuum chuck (302) having a groove (310) adapted to decouple the inner region (318) and the outer region (316), wherein the inner and outer regions of the vacuum chuck are arranged to move independently in a direction orthogonal to a polishing surface of the polishing pad; and
a retainer ring (304) disposed on the outer region of the vacuum chuck and configured to retain the wafer during CMP processing, wherein the decoupled retainer ring (304) and the wafer (308) are arranged to move independently to align to the polishing surface of the polishing pad during the CMP processing **characterized in that** the vacuum chuck (302) is elastomeric so as to allow the decoupled retainer ring (304) and the wafer (308) to move independently.

2. The wafer carrier as recited in claim 1, wherein the vacuum chuck (302) is cylindrical with a circular surface, wherein the retainer ring (304) is disposed around the edge of the vacuum chuck in a ring configuration.

3. The wafer carrier as recited in claim 1, wherein the polishing surface defines a plane and wherein the vacuum chuck (302) is arranged to align the decoupled retainer ring (304) and the wafer (308) align to the same plane of the polishing surface.

4. The wafer carrier as recited in claim 1, wherein the retaining ring (304) is configured to mask edge effects on the wafer.

5. The wafer carrier as recited in claim 1, wherein the retaining ring (304) includes a leading edge to mask an edge of the wafer.

6. The wafer carrier as recited in claim 1, wherein the leading edge of the retaining ring is rounded.

7. A chemical mechanical planarization (CMP) system, comprising:
a polishing pad (502); and
a wafer carrier (300), the wafer carrier including a vacuum chuck (302) configured to hold and rotate a wafer (308) for planarizing a surface topography of the wafer on the polishing pad, the vacuum chuck including an inner region (318) for holding the wafer and an outer region (316), the vacuum chuck being elastomeric and having a groove (310) adapted to decouple the inner region and the outer region, wherein the inner and outer regions of the vacuum chuck are arranged to move independently in a direction orthogonal to a polishing surface of the polishing pad, the wafer carrier further including a retainer ring (304) disposed on the outer region of the vacuum chuck and configured to retain the wafer during CMP processing, wherein the decoupled retainer ring (304) and the wafer (308) are arranged to move independently to align to a plane defining the polishing surface of the polishing pad during the CMP processing.

8. The CMP system of claim 7, wherein the vacuum chuck (302) is cylindrical with a circular surface, wherein the retainer ring (304) is disposed around the edge of the vacuum chuck in a ring configuration.

9. The CMP system of claim 7, wherein the retaining ring (304) is configured to mask edge effects on the wafer.

10. The CMP system of claim 7, wherein the retaining ring (304) includes a leading edge to mask an edge of the wafer.

11. The CMP system of claim 10, wherein the leading edge of the retaining ring (304) is rounded.

12. A method for making a wafer carrier for use with a chemical mechanical planarization apparatus, comprising:
forming a vacuum chuck (302) configured to hold and rotate a wafer (308) for planarizing a surface topography of the wafer on a polishing pad (502), the vacuum chuck including an inner region (318) for holding the wafer and an outer region (316), the forming of the vacuum chuck further including the forming of a groove (310) adapted to decouple the inner region and the outer region, wherein the inner and outer regions of the vacuum chuck are arranged to move independently of each other; and
forming a retainer ring (304) to be disposed on the outer region (316) of the vacuum chuck and configured to retain the wafer during CMP processing, wherein the retainer ring (304) and the wafer (308) are arranged to move independently in a direction orthogonal to the polishing surface of the polishing pad such that the retainer ring (304) and the wafer (308) align to the polishing surface of the polishing pad, **characterized in that** an elastomeric is used in the forming of the vacuum chuck (302) to allow the decoupled retainer ring (304) and the wafer (308) to move independently.

13. A method for making a wafer carrier as recited in claim 12, wherein the forming of the vacuum chuck (302) includes defining the vacuum chuck cylindrically and with a circular surface, wherein the retainer ring (304) is configured to be disposed around the edge of the vacuum chuck in a ring configuration.

14. A method for making a wafer carrier as recited in claim 12, wherein the polishing surface defines a plane and wherein the vacuum chuck (302) is arranged to align the decoupled retainer ring and the wafer align to the same plane of the polishing surface.

15. A method for making a wafer carrier as recited in claim 12, wherein the retaining ring (304) is configured to mask edge effects on the wafer.

16. A method for making a wafer carrier as recited in claim 12, wherein the retaining ring (304) includes a leading edge to mask an edge of the wafer.

17. A method for making a wafer carrier as recited in claim 16, wherein the leading edge of the retaining ring (304) is made to be rounded.

18. A method for making a wafer carrier as recited in claim 12, wherein the retaining ring (304) is formed of an elastic material.

## Patentansprüche

1. Waferträger (300) zur Verwendung bei einer Vorrichtung zur chemisch-mechanischen Planarisierung, mit:
einer Vakuumaufspannvorrichtung (302), die dazu ausgelegt ist, einen Wafer (308) zum Planarisieren einer Oberflächentopographie des Wafers auf einem Polierkissen zu halten und zu drehen, wobei die Vakuumaufspannvorrichtung (302) einen inneren Bereich zum Halten des Wafers und einen äußeren Bereich umfaßt, wobei die Vakuumaufspannvorrichtung (302) eine Nut (310) aufweist, die dazu ausgelegt ist, den inneren Bereich (318) und den äußeren Bereich (316) zu entkoppeln, wobei der innere und der äußere Bereich der Vakuumaufspannvorrichtung angeordnet sind, um sich unabhängig voneinander in einer zu einer Polieroberfläche des Polierkissens senkrechten Richtung zu bewegen; und
einem Haltering (304), der am äußeren Bereich der Vakuumaufspannvorrichtung angeordnet ist und dazu ausgelegt ist, den Wafer während der CMP-Bearbeitung festzuhalten, wobei der abgekoppelte Haltering (304) und der Wafer (308) angeordnet sind, um sich unabhängig voneinander zu bewegen, um auf die Polieroberfläche des Polierkissens während der CMP-Bearbeitung auszurichten, **dadurch gekennzeichnet, daß** die Vakuumaufspannvorrichtung (302) elastomer ist, um zu ermöglichen, daß sich der abgekoppelte Haltering (304) und Wafer (308) unabhängig voneinander bewegen.

2. Waferträger nach Anspruch 1, wobei die Vakuumaufspannvorrichtung (302) zylindrisch mit einer kreisförmigen Oberfläche ist, wobei der Haltering (304) um die Kante der Vakuumaufspannvorrichtung in einer Ringgestalt angeordnet ist.

3. Waferträger nach Anspruch 1, wobei die Polieroberfläche eine Ebene definiert und wobei die Vakuumaufspannvorrichtung (302) angeordnet ist, um den abgekoppelten Haltering (304) und den Wafer (308) auf dieselbe Ebene der Polieroberfläche auszurichten.

4. Waferträger nach Anspruch 1, wobei der Haltering (304) dazu ausgelegt ist, Kanteneffekte auf dem Wafer zu maskieren.

5. Waferträger nach Anspruch 1, wobei der Haltering (304) eine Vorderkante umfaßt, um eine Kante des Wafers zu maskieren.

6. Waferträger nach Anspruch 1, wobei die Vorderkante des Halterings abgerundet ist.

7. System zum chemisch-mechanischen Planarisieren (CMP) mit:
einem Polierkissen (502); und
einem Waferträger (300), wobei der Waferträger eine Vakuumaufspannvorrichtung (302) umfaßt, die dazu ausgelegt ist, einen Wafer (308) zum Planarisieren einer Oberflächentopographie des Wafers auf dem Polierkissen zu-halten und zu drehen, wobei die Vakuumaufspannvorrichtung einen inneren Bereich (318) zum Halten des Wafers und einen äußeren Bereich (316) umfaßt, wobei die Vakuumaufspannvorrichtung elastomer ist und eine Nut (310) aufweist, die dazu ausgelegt ist, den inneren Bereich und den äußeren Bereich zu entkoppeln, wobei der innere und der äußere Bereich der Vakuumaufspannvorrichtung angeordnet sind, um sich unabhängig voneinander in einer zu einer Polieroberfläche des Polierkissens senkrechten Richtung zu bewegen, wobei der Waferträger ferner einen Haltering (304) umfaßt, der am äußeren Bereich der Vakuumaufspannvorrichtung angeordnet ist und dazu ausgelegt ist, den Wafer während der CMP-Bearbeitung festzuhalten, wobei der abgekoppelte Haltering (304) und der Wafer (308) angeordnet sind, um sich unabhängig voneinander zu bewegen, um auf eine Ebene, die die Polieroberfläche des Polierkissens definiert, während der CMP-Bearbeitung auszurichten.

8. CMP-System nach Anspruch 7, wobei die Vakuumaufspannvorrichtung (302) zylindrisch mit einer kreisförmigen Oberfläche ist, wobei der Haltering (304) um die Kante der Vakuumaufspannvorrichtung in einer Ringgestalt angeordnet ist.

9. CMP-System nach Anspruch 7, wobei der Haltering (304) dazu ausgelegt ist, Kanteneffekte auf dem Wafer zu maskieren.

10. CMP-System nach Anspruch 7, wobei der Haltering (304) eine Vorderkante umfaßt, um eine Kante des Wafers zu maskieren.

11. CMP-System nach Anspruch 10, wobei die Vorderkante des Halterings (304) abgerundet ist.

12. Verfahren zur Herstellung eines Waferträgers zur Verwendung bei einer Vorrichtung zum chemisch-mechanischen Planarisieren, umfassend:
Ausbilden einer Vakuumaufspannvorrichtung (302), die dazu ausgelegt ist, einen Wafer (308) zum Planarisieren einer Oberflächentopographie des Wafers auf einem Polierkissen (502) zu halten und zu drehen, wobei die Vakuumaufspannvorrichtung einen inneren Bereich (318) zum Halten des Wafers und einen äußeren Bereich (316) umfaßt, wobei das Ausbilden der Vakuumaufspannvorrichtung ferner das Ausbilden einer Nut (310) umfaßt, die dazu ausgelegt ist, den inneren Bereich und den äußeren Bereich zu entkoppeln, wobei der innere und der äußere Bereich der Vakuumaufspannvorrichtung angeordnet sind, um sich unabhängig voneinander zu bewegen; und
Ausbilden eines Halterings (304), der am äußeren Bereich (316) der Vakuumaufspannvorrichtung angeordnet werden soll und dazu ausgelegt ist, den Wafer während der CMP-Bearbeitung festzuhalten, wobei der Haltering (304) und der Wafer (308) angeordnet sind, um sich unabhängig voneinander in einer zur Polieroberfläche des Polierkissens senkrechten Richtung zu bewegen, so daß sich der Haltering (304) und der Wafer (308) auf die Polieroberfläche des Polierkissens ausrichten, **dadurch gekennzeichnet, daß** ein Elastomer bei der Ausbildung der Vakuumaufspannvorrichtung (302) verwendet wird, um zu ermöglichen, daß sich der entkoppelte Haltering (304) und der Wafer (308) unabhängig voneinander bewegen.

13. Verfahren zur Herstellung eines Waferträgers nach Anspruch 12, wobei das Ausbilden der Vakuumaufspannvorrichtung (302) das Festlegen der Vakuumaufspannvorrichtung zylindrisch und mit einer kreisförmigen Oberfläche umfaßt, wobei der Haltering (304) dazu ausgelegt ist, um die Kante der Vakuumaufspannvorrichtung in einer Ringgestalt angeordnet zu werden.

14. Verfahren zur Herstellung eines Waferträgers nach Anspruch 12, wobei die Polieroberfläche eine Ebene definiert und wobei die Vakuumaufspannvorrichtung (302) angeordnet ist, um den abgekoppelten Haltering und den Wafer auf dieselbe Ebene der Polieroberfläche auszurichten.

15. Verfahren zur Herstellung eines Waferträgers nach Anspruch 12, wobei der Haltering (304) dazu ausgelegt ist, Kanteneffekte auf dem Wafer zu maskieren.

16. Verfahren zur Herstellung eines Waferträgers nach Anspruch 12, wobei der Haltering (304) eine Vorderkante umfaßt, um eine Kante des Wafers zu maskieren.

17. Verfahren zur Herstellung eines Waferträgers nach Anspruch 16, wobei die Vorderkante des Halterings (304) so hergestellt wird, daß sie abgerundet ist.

18. Verfahren zur Herstellung eines Waferträgers nach Anspruch 12, wobei der Haltering (304) aus einem elastischen Material ausgebildet wird.

## Revendications

1. Support (300) de tranche destiné à être utilisé avec un appareil de planarisation chimico-mécanique(CMP) comprenant :
- un support individuel (302) de tranche à vide configuré pour maintenir et faire tourner une tranche (308) afin de planariser une topographie de surface de la tranche sur un tampon à polir, le support individuel (302) de tranche à vide comprenant une zone interne destinée à maintenir la tranche et une zone externe, le support individuel (302) de tranche à vide présentant une rainure (310) adaptée pour découpler la zone interne (318) et la zone externe (316), les zones interne et externe du support individuel de tranche à vide étant agencées pour se déplacer de manière indépendante dans une direction orthogonale à une surface de polissage du tampon à polir ; et
- une bague de retenue (304) disposée sur la zone externe du support individuel de tranche à vide et configurée pour retenir la tranche pendant le traitement CMP, la bague de retenue (304) découplée et la tranche (308) étant agencées pour se déplacer de manière indépendante afin de s'aligner avec la surface de polissage du tampon à polir pendant le traitement CMP, **caractérisé en ce que** le support individuel (302) de tranche à vide est élastomère de manière à permettre à la bague de retenue (304) découplée et à la tranche (308) de se déplacer de façon indépendante.

2. Support de tranche selon la revendication 1, dans lequel le support individuel (302) de tranche à vide est cylindrique avec une surface circulaire, la bague de retenue (304) étant disposée autour du bord du support individuel de tranche à vide selon une configuration en anneau.

3. Support de tranche selon la revendication 1, dans lequel la surface de polissage définit un plan et dans lequel le support individuel (302) de tranche à vide est agencé pour aligner la bague de retenue (304) découplée et la tranche (308) sur le même plan de la surface de polissage.

4. Support de tranche selon la revendication 1, dans lequel la bague de retenue (304) est configurée pour masquer les effets de bord sur la tranche.

5. Support de tranche selon la revendication 1, dans lequel la bague de retenue (304) comprend un bord d'attaque destiné à masquer un bord de la tranche.

6. Support de tranche selon la revendication 1, dans lequel le bord d'attaque de la bague de retenue est arrondi.

7. Système de planarisation chimico-mécanique (CMP), comprenant :
- un tampon à polir (502) ; et
- un support (300) de tranche, le support de tranche comprenant un support individuel (302) de tranche à vide configuré pour maintenir et faire tourner une tranche (308) afin de planariser une topographie de surface de la tranche sur le tampon à polir, le support individuel de tranche à vide comprenant une zone interne (318) destinée à maintenir la tranche et une zone externe (316), le support individuel de tranche à vide étant élastomère et présentant une rainure (310) adaptée pour découpler la zone interne et la zone externe, les zones interne et externe du support individuel de tranche à vide étant agencés pour se déplacer de manière indépendante dans une direction orthogonale à une surface de polissage du tampon à polir, le support de tranche comprenant en outre une bague de retenue (304) disposée sur la zone externe du support individuel de tranche à vide et configurée pour retenir la tranche pendant le traitement CMP, la bague de retenue (304) découplée et la tranche (308) étant agencées pour se déplacer de manière indépendante afin de s'aligner par rapport à un plan définissant la surface de polissage du tampon à polir pendant le traitement CMP.

8. Système CMP selon la revendication 7, dans lequel le support individuel (302) de tranche à vide est cylindrique avec une surface circulaire, la bague de retenue (304) étant disposée autour du bord du support individuel de tranche à vide selon une configuration en anneau.

9. Système CMP selon la revendication 7, dans lequel la bague de retenue (304) est configurée pour masquer les effets de bord sur la tranche.

10. Système CMP selon la revendication 7, dans lequel la bague de retenue (304) comprend un bord d'attaque afin de masquer un bord de la tranche.

11. Système CMP selon la revendication 10, dans lequel le bord d'attaque de la bague de retenue (304) est arrondi.

12. Procédé de fabrication d'un support de tranche destiné à être utilisé avec un appareil de planarisation chimico-mécanique (CMP), comprenant:
- la formation d'un support individuel (302) de tranche à vide configuré pour maintenir et faire tourner une tranche (308) afin de planariser une topographie de surface de la tranche sur un tampon à polir (502), le support individuel de tranche à vide comprenant une zone interne (318) destinée à maintenir la tranche et une zone externe (316), la formation du support individuel de tranche à vide comprenant en outre la formation d'une rainure (310) adaptée pour découpler la zone interne et la zone externe, les zones interne et externe du support individuel de tranche à vide étant agencées pour se déplacer de manière indépendante l'une de l'autre ; et
- la formation d'une bague de retenue (304) destinée à être disposée sur la zone externe (316) du support individuel de tranche à vide et configurée pour retenir la tranche pendant le traitement CMP, la bague de retenue (304) et la tranche (308) étant agencées pour se déplacer de manière indépendante dans une direction orthogonale à la surface de polissage du tampon à polir de telle sorte que la bague de retenue (304) et la tranche (308) s'alignent avec la surface de polissage du tampon à polir, **caractérisé en ce qu'**un élastomère est utilisé lors de la formation du support individuel (302) de tranche à vide afin de permettre à la bague de retenue (304) découplée et à la tranche (308) de se déplacer de manière indépendante.

13. Procédé de fabrication d'un support de tranche selon la revendication 12, dans lequel la formation du support individuel (302) de tranche à vide comprend la définition du support individuel de tranche à vide de manière cylindrique et avec une surface circulaire, la bague de retenue (304) étant configurée pour être disposée autour du bord du support individuel de tranche à vide selon une configuration en anneau.

14. Procédé de fabrication d'un support de tranche selon la revendication 12, dans lequel la surface de polissage définit un plan et dans lequel le support individuel (302) de tranche à vide (302) est agencé pour aligner la bague de retenue découplée et la tranche sur le même plan de la surface de polissage.

15. Procédé de fabrication d'un support de tranche selon la revendication 12, dans lequel la bague de retenue (304) est configurée pour masquer les effets de bord sur la tranche.

16. Procédé de fabrication d'un support de tranche selon la revendication 12, dans lequel la bague de retenue (304) comprend un bord d'attaque destiné à masquer un bord de la tranche.

17. Procédé de fabrication d'un support de tranche selon la revendication 16, dans lequel le bord d'attaque de la bague de retenue (304) est arrondi.

18. Procédé de fabrication d'un support de tranche selon la revendication 12, dans lequel la bague de retenue (304) est formée en matériau élastique.
